# EUROPEAN PATENT SPECIFICATION

(11) **EP 4 395 078 B1**
(45) Date of publication and mention of the grant of the patent: **08.10.2025**
(21) Application number: 22217447.6
(22) Date of filing: 31.12.2022
(51) Int. Cl.: H01R 12/52, H01R 12/70, H01R 12/73, H05K 1/14, H05K 7/12, F21S 41/19, F21S 43/19

(54) **AUTOMOTIVE LUMINOUS DEVICE**
LEUCHTVORRICHTUNG FÜR KRAFTFAHRZEUGE
DISPOSITIF LUMINEUX POUR AUTOMOBILE

(43) Date of publication of application: 03.07.2024
(73) Proprietor: Valeo Vision, 93012 Bobigny Cedex (FR)
(72) Inventor: CANTUDO FRANCO, Miguel Angel, 23600 MARTOS (ES); ROLDAN ZAFRA, Jose David, 23600 MARTOS (ES)
(74) Representative: Valeo Visibility

(56) References cited:
- EP-A1- 1 898 681
- DE-A1- 102011 051 153
- FR-A1- 3 116 588
- US-A1- 2003 071 581
- US-A1- 2005 213 321
- US-A1- 2017 179 103
- US-A1- 2019 252 810
- US-A1- 2022 065 424

## Description

### TECHNICAL FIELD

This invention belongs to the field of the arrangements of the elements of an automotive luminous device.

### STATE OF THE ART

Automotive lighting market can be considered one of the most competitive ones and new lighting functions are constantly required.

There are some luminous designs where light needs to be emitted from different light sources in different planes or different directions. This is often used in some signalling functions, where tight space and car manufacturers' specifications require some creative solutions. Further, long printed circuit boards are not always the best solution, and connection between smaller printed circuit boards are needed. Several groups of harnesses are needed to provide the electric connection between different substrates, and this is not always possible, due to tight space within lighting devices.

Further, these harnesses create some electromagnetic problems caused by antenna structures created by the harnesses and by the loops in the electric signals.

Patent application DE102011051153 A1 describes an electrical connection device for lighting devices, using plastically deformable conductors that allow for adjustable distances between electronic components, such as LEDs.

Patent application EP1898681 A1 describes a method of electrically connecting two substrates using conventional bonding techniques, such as ultrasonic wire bonding. The bonding connections can be elastically/plastically deformed allowing the substrates to be positioned in different configurations.

Flexible solutions are usually expensive, so a new way of arranging these substrates is sought, to avoid or at least mitigate the aforementioned problems.

### DESCRIPTION OF THE INVENTION

The present invention provides an alternative solution for these problems by means of an automotive luminous device.

This automotive luminous device comprises
a main support;
a first rigid plane substrate arranged on the main support and comprising first terminals;
a second rigid plane substrate arranged on the main support and comprising second terminals, wherein at least one of the rigid plane substrates comprises at least one light source; and
a connector comprising a connector body and a plurality of conductive wires, each conductive wire comprising a first end elastically deformed against one of the first terminals and a second end elastically deformed against one of the second terminals, in such a way that each end of each conductive wire exerts a recovery force against the corresponding terminal and in such a way each conductive wire provides electric connection between one first terminal and one second terminal.

The connector comprises fixing means to create a joint between the connector and the main support, wherein the fixing means are configured to prevent rotation and translation between the connector and the main support.

A rigid substrate should be understood in the sense of what the skilled person would construe. A skilled person knows the difference between a rigid substrate and a flexible substrate. Although every material is "flexible" in the sense that it has a stress-strain curve, a substrate which does not apparently deform by its own weight when held by one of its ends is deemed to be rigid, while a substrate which suffer a substantial deformation when held by one of its ends is considered to be flexible. In any case, board manufacturers offer a "flexible" model and a "rigid" model, while any skilled person knows the difference between them.

With this connector, the rigid plane substrates can be reliably connected despite they may be oriented in different planes. Further, there is no need to provide a connector per each substrate, since a single connector may be used to connect both substrates.

In some particular embodiments, the main support is a housing, an optical element, or a bezel.

The connector may be installed in any of these elements, that can be found in standard automotive lighting devices.

In some particular embodiments, the main support is an auxiliary part installed in a housing, an optical element, or a bezel.

It is often useful to put an auxiliary part between the main support and the connector, since it is sometimes advisable that the connector is higher than the substrates, so that the conductive wires may be arranged to exert the suitable force against the terminals.

In some particular embodiments, the optical element is a reflector, a lens or a light guide.

In some particular embodiments, the fixing means comprises a screw.

A screw is adequate, because it prevents the connector from moving in the vertical direction (the direction of the insertion of the screw) and also in a plane perpendicular to the insertion direction. Further, if the torque is enough, the screw is also useful to prevent rotation of the connector, so that the conductive wires do not deviate from the corresponding terminals.

In some particular embodiments, the fixing means comprises a protrusion and the main support comprises a hollow portion configured to receive the protrusion.

An auxiliar protrusion is also useful to prevent the connector from rotate with respect to the substrates, so that the conductive wires do not deviate from the corresponding terminals.

In some particular embodiments, the protrusion is a pin or a longitudinal protrusion.

A pin or a longitudinal protrusion may match in the corresponding hollow portion to ensure anti-rotation properties.

In some particular embodiments, the fixing means comprises a clip joint.

A clip joint, which may be designed in the connector or in the main support, is also a good option for fixing the connector to the main support.

In some particular embodiments, the first rigid plane substrate and the second rigid plane substrate are parallel or contained in the same plane.

Standard lighting devices comprises different substrates which are contained in the same plane. This is the case when the surface to be lit is too large or when the electronics require splitting between different substrates.

In some particular embodiments, the first rigid plane substrate and the second rigid plane substrate form an angle comprised between 60° and 300°.

The invention may also be applied when the two rigid plane substrates are not contained in the same plane or in parallel planes. The effect of the force exerted by the conductive wires can be applied in the case of this relative inclination between the substrates.

The angle between the rigid plane substrates is measured in the faces which contains the terminals which are contacted by the conductive wires.

In some particular embodiments, the connector is installed on a raising element, so that the distance between the connector and the main support is greater than the distance between the rigid plane substrates and the main support.

In some particular embodiments, each rigid plane substrate comprises an optical element arranged to receive the light emitted by the corresponding light source and project the light in a projection direction.

An optical element is an element that has some optical properties to receive a light beam and emit it in a certain direction and/or shape, as a person skilled in automotive lighting would construe without any additional burden. Reflectors, collimators, light guides, projection lenses, etc., or the combination thereof are some examples of these optical elements which are useful for transforming the light beams emitted by the light source into an acceptable light pattern for the functionality chosen for the lighting device.

In some particular embodiments, the automotive luminous device further comprises an outer lens configured to receive light emitted by the light sources and project it outside the luminous device.

In some particular embodiments, the light sources are solid-state light sources.

The term "solid state" refers to light emitted by solid-state electroluminescence, which uses semiconductors to convert electricity into light. Compared to incandescent lighting, solid state lighting creates visible light with reduced heat generation and less energy dissipation. The typically small mass of a solid-state electronic lighting device provides for greater resistance to shock and vibration compared to brittle glass tubes/bulbs and long, thin filament wires. They also eliminate filament evaporation, potentially increasing the lifespan of the illumination device. Some examples of these types of lighting comprise semiconductor light-emitting diodes (LEDs), organic light-emitting diodes (OLED), or polymer light-emitting diodes (PLED) as sources of illumination rather than electrical filaments, plasma or gas.

Unless otherwise defined, all terms (including technical and scientific terms) used herein are to be interpreted as is customary in the art. It will be further understood that terms in common usage should also be interpreted as is customary in the relevant art and not in an idealised or overly formal sense unless expressly so defined herein.

In this text, the term "comprises" and its derivations (such as "comprising", etc.) should not be understood in an excluding sense, that is, these terms should not be interpreted as excluding the possibility that what is described and defined may include further elements, steps, etc.

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figure 1 shows a portion of a first embodiment of an automotive luminous device according to the invention.
Figures 2a and 2b show the shape of the conductive wires in rest and when installed in the automotive luminous device of the invention.
Figure 3 shows a detail of an alternative arrangement of the screw in a different embodiment of an automotive luminous device according to the invention.
Figure 4 shows a plan view of the arrangement of the conductive wires around the screw, to avoid any short circuit.
Figures 5 and 6 show different examples of the relative orientation of the rigid printed circuit boards in different embodiments of an automotive lighting device according to the invention.
Figure 7 shows an automotive luminous device 10 according to the invention, installed in an automotive vehicle 100.

In these figures, the following reference numbers have been used
- 1: First printed circuit board
- 2: Second printed circuit board
- 3: Housing
- 4: First electric terminal
- 5: Second electric terminal
- 6: LED
- 7: Connector
- 8: Connector body
- 9: Conductive wires
- 10: Headlamp
- 11: First end of the conductive wire
- 12: Second end of the conductive wire
- 13: Screw
- 14: Rising part
- 15: Reflector
- 16: Outer lens
- 17: Pin
- 18: Hollow receptacle for the pin

### DETAILED DESCRIPTION OF THE INVENTION

The example embodiments are described in sufficient detail to enable those of ordinary skill in the art to embody and implement the systems and processes herein described. It is important to understand that embodiments can be provided in many alternate forms and should not be construed as limited to the examples set forth herein.

Accordingly, while embodiment can be modified in various ways and take on various alternative forms, specific embodiments thereof are shown in the drawings and described in detail below as examples. There is no intent to limit to the particular forms disclosed. On the contrary, all modifications, and alternatives falling within the scope of the appended claims should be included. Elements of the example embodiments are consistently denoted by the same reference numerals throughout the drawings and detailed description where appropriate.

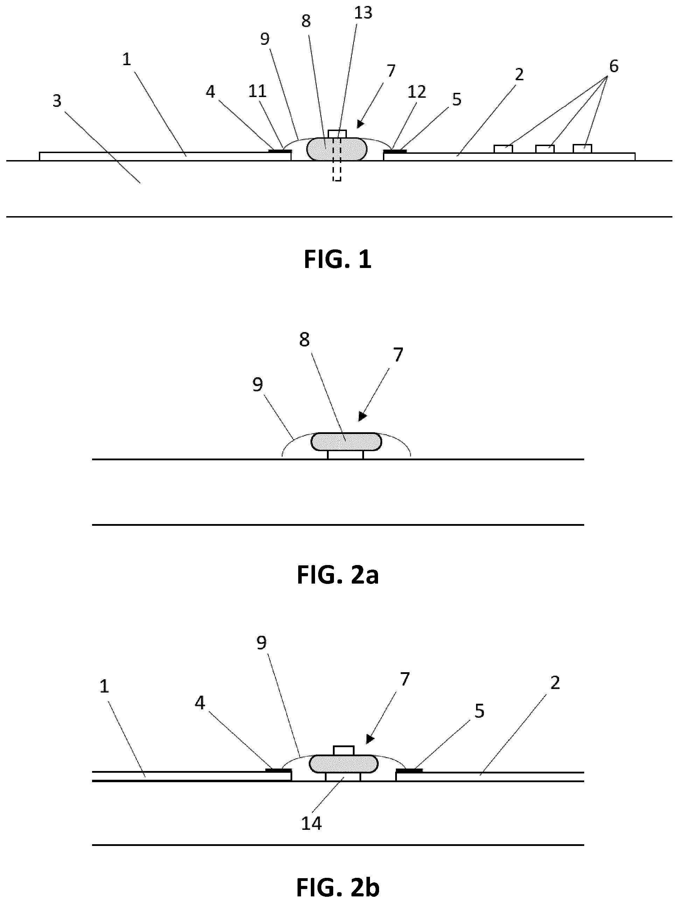

Figure 1 shows a portion of a first embodiment of an automotive luminous device according to the invention.

In this portion, the following elements are found: a portion of a housing 3, a first rigid printed circuit board 1 arranged on the housing, a second printed circuit board 2 arranged on the housing 3 and a connector 7 which is intended to create an electric connection between both printed circuit boards 1, 2.

The first printed circuit board 1 comprises first electric terminals 4 and the second printed circuit board 2 comprises three LEDs 6 and second electric terminals 5. The LEDs 6 of the second printed circuit board 2 are intended to be commanded by instructions received at the first printed circuit board 1, so an electric connection between both printed circuit boards 1, 2 is required.

The connector 7 comprises a connector body 8 and a plurality of conductive wires 9, the same number of conductive wires as the first and second terminals 4, 5. In this case, since the first printed circuit board 1 and the second printed circuit board 2 comprises five terminals, the connector 7 comprises five conductive wires 9.

Each conductive wire 9 has a first end 11 elastically deformed against one of the first terminals 4 and a second end 12 elastically deformed against one of the second terminals 5, in such a way that each end of each conductive wire 9 exerts a recovery force against the corresponding terminal 4, 5. Since each end of the same conductive wire is forced to be in contact with one first terminal 4 and one second terminal 5, each conductive wire 9 provides electric connection between one first terminal 4 and one second terminal 5.

Further, the connector 7 comprises a screw 13 to create a joint between the connector 7 and the housing 3. The screw 13 is installed with a torque enough to prevent rotation between the connector 7 and the housing 3. Because of the nature of the screw 13, translation in any direction is also not allowed.

In this case, the connector 7 is installed in a portion of the housing 3. However, in different embodiments, it could be installed in an optical element or in a bezel. Even in other embodiments, an auxiliary part may be installed in any of these locations, and provide support for the connector.

Figures 2a and 2b show the shape of the conductive wires in rest and when installed in the automotive luminous device of the invention.

Figure 2a shows the arrangement of the conductive wires 9 of a connector 7 which is to be installed in an automotive luminous device of the invention.

As seen in this figure, when the conductive wires 9 are in rest, their position is low. This is not due to its weight, but to the intentional shape provided to the wires.

Figure 2b shows the arrangement of the conductive wires 9 of the connector 7 when the printed circuit boards 1, 2 are installed.

In this case, the printed circuit boards are contained in the same plane. In any case, it is observed how the conductive wires 9 are deformed to match the position against the corresponding conductive terminals 4, 5 of the printed circuit boards.

Due to this deformation, there is a force that presses each conductive wire against the corresponding terminals 4, 5, thus ensuring their electric contact.

In this figure 2b, it is observed how the connector 7 is installed on a raising element 14, so that the distance between the connector 7 and the housing 3 is greater than the distance between the rigid plane substrates 1, 2 and the housing 3. Therefore, the force may be controlled to be optimal.

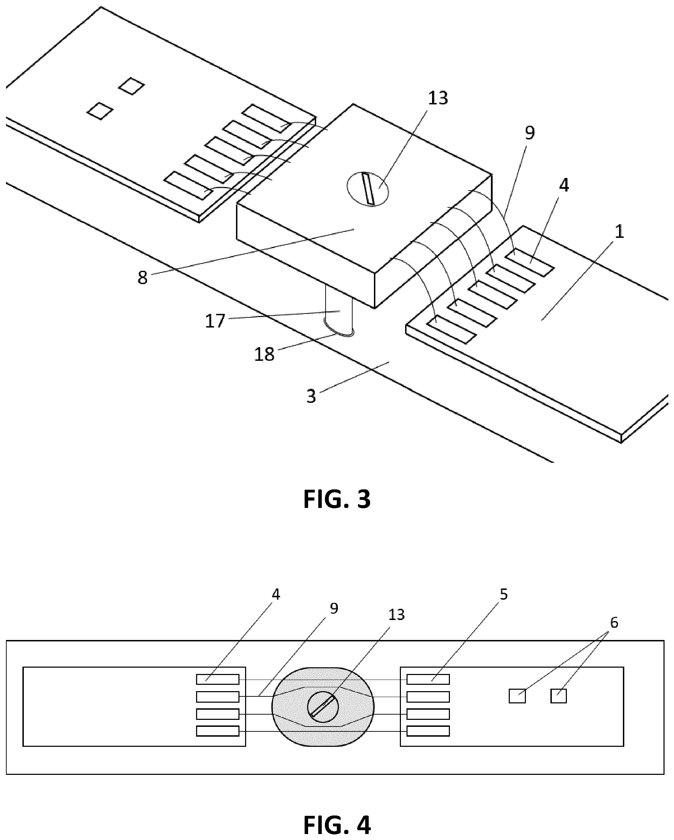

Figure 3 shows a detail of an alternative arrangement of the screw 13 in a different embodiment of an automotive luminous device according to the invention.

In this case, the torque of the screw is not carefully controlled, and the screw 13 is only used to prevent linear movements in any of the three dimensions of the space.

Rotation is prevented by the insertion of a protrusion 17 in a hollow portion 18 located in the housing 3. In this case, the protrusion is an ellipsoidal pin 17, but this protrusion could have any shape provided that the corresponding hollow portion has a matching shape which prevents rotation.

In these cases, the screw could be replaced by a clip joint, since the prevention of rotation is now provided by a different element.

Figure 4 shows a plan view of the arrangement of the conductive wires 9 around the screw 13, to avoid any short circuit.

As seen in this figure, the conductive wires 9 are bended to avoid contacting the screw 13, which crosses the connector body 8 until threading in the corresponding threaded portion of the housing 3. The conductive wires 9 provide the electric connection between the first terminals 4 and the second terminals 5 without contacting any other conductive element, thus avoiding a short circuit.

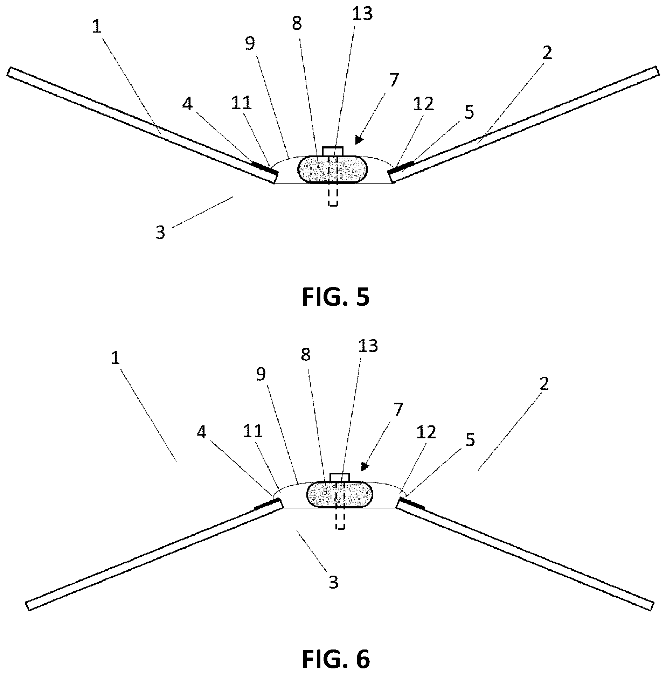

Figures 5 and 6 show different examples of the relative orientation of the rigid printed circuit boards 1, 2 in different embodiments of an automotive lighting device according to the invention.

In figure 5, the rigid printed circuit boards are provided forming an angle of 120°. The angle is measured in the faces which contain the terminals 4, 5. Since the conductive wires are forced against the terminals 4, 5, as explained in Figures 2a and 2b, the electric connection is ensured.

In figure 6, the rigid printed circuit boards are provided forming an angle of 240°. The angle is measured in the faces which contain the terminals 4, 5. Since the conductive wires are forced against the terminals 4, 5, as explained in Figures 2a and 2b, the electric connection is ensured.

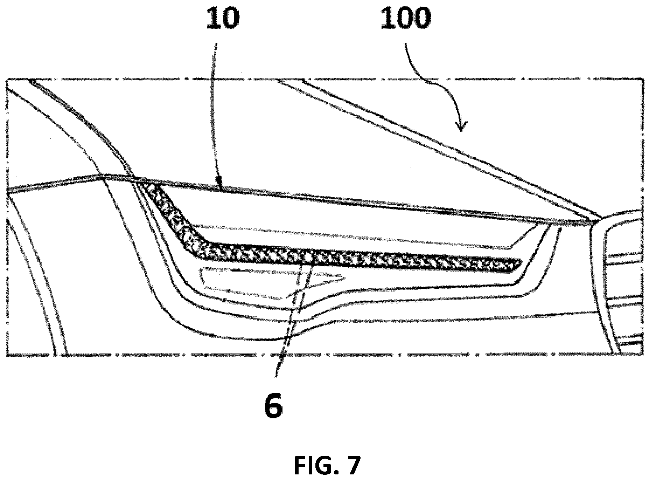

Figure 7 shows an automotive luminous device 10 according to the invention, installed in an automotive vehicle 100. The light emitted by the LEDs of the second printed circuit board 2 is reflected by a reflector 15 and projected outside the luminous device 10 by an outer lens 16.

## Claims

1. Automotive luminous device (10) comprising
a main support (3);
a first rigid plane substrate (1) arranged on the main support (3) and comprising first terminal (4);
a second rigid plane substrate (2) arranged on the main support and comprising second terminals (5), wherein at least one of the rigid plane substrates (1, 2) comprises at least one light source (6); and
a connector (7) comprising a connector body (8) and a plurality of conductive wires (9), each conductive wire (9) comprising a first end (11) elastically deformed against one of the first terminals (4) and a second end (12) elastically deformed against one of the second terminals (5),
**characterized in that** each end of each conductive wire (9) exerts a recovery force against the corresponding terminal (4, 5) and in such a way each conductive wire (9) provides electric connection between one first terminal (4) and one second terminal (5);
wherein the connector (7) comprises fixing means (13) to create a joint between the connector and the main support, wherein the fixing means are configured to prevent rotation and translation between the connector and the main support.

2. Automotive luminous device (10) according to claim 1, wherein the main support is a housing, an optical element, or a bezel.

3. Automotive luminous device (10) according to claim 1, wherein the main support is an auxiliary part installed in a housing, an optical element, or a bezel.

4. Automotive luminous device (10) according to any of claims 2 or 3, wherein the optical element is a reflector, a lens or a light guide.

5. Automotive luminous device (10) according to any of the preceding claims, wherein the fixing means comprises a screw (13).

6. Automotive luminous device (10) according to any of the preceding claims, wherein the fixing means comprises a protrusion and the main support comprises a hollow portion configured to receive the protrusion.

7. Automotive luminous device (10) according to claim 6, wherein the protrusion is a pin or a longitudinal protrusion.

8. Automotive luminous device (10) according to any of the preceding claims, wherein the fixing means comprises a clip joint.

9. Automotive luminous device (10) according to any of the preceding claims, wherein the first rigid plane substrate (1) and the second rigid plane substrate (2) are parallel or contained in the same plane.

10. Automotive luminous device (10) according to any of claims 1 to 8, wherein the first rigid plane substrate (1) and the second rigid plane substrate (2) form an angle comprised between 60° and 300°.

11. Automotive luminous device (10) according to any of the preceding claims, wherein the connector is installed on a raising element (14), so that the distance between the connector and the main support is greater than the distance between the rigid plane substrates and the main support.

12. Automotive luminous device according to any of the preceding claims, wherein each rigid plane substrate (1, 2) comprises an optical element (15) arranged to receive the light emitted by the corresponding light source (6) and project the light in a projection direction.

13. Automotive luminous device according to any of the preceding claims, further comprising an outer lens (16) configured to receive light emitted by the light sources and project it outside the luminous device.

14. Automotive luminous device (10) according to any of the preceding claims, wherein the light sources (6) are solid-state light sources.

## Patentansprüche

1. Lichtvorrichtung (10) für Kraftfahrzeuge,
umfassend einen Hauptträger (3);
einem ersten starren, ebenen Substrat (1), das auf dem Hauptträger (3) angeordnet ist und einen ersten Anschluss (4) umfasst;
einem zweiten starren, ebenen Substrat (2), das auf dem Hauptträger angeordnet ist und zweite Anschlüsse (5) umfasst, wobei mindestens eines der starren, ebenen Substrate (1, 2) mindestens eine Lichtquelle (6) umfasst; und
ein Verbinder (7), der einen Verbinderkörper (8) und mehrere leitfähige Drähte (9) umfasst, wobei jeder leitfähige Draht (9) ein erstes Ende (11), das elastisch gegen einen der ersten Anschlüsse (4) verformt ist, und ein zweites Ende (12) umfasst, das elastisch gegen einen der zweiten Anschlüsse (5) verformt ist,
**dadurch gekennzeichnet, dass** jedes Ende jedes leitfähigen Drahtes (9) eine Rückstellkraft gegen den entsprechenden Anschluss (4, 5) ausübt, so dass jeder leitfähige Draht (9) eine elektrische Verbindung zwischen einem ersten Anschluss (4) und einem zweiten Anschluss (5) herstellt;
wobei der Verbinder (7) Befestigungsmittel (13) umfasst, um eine Verbindung zwischen dem Verbinder und dem Hauptträger herzustellen, wobei die Befestigungsmittel so konfiguriert sind, dass sie eine Drehung und Verschiebung zwischen dem Verbinder und dem Hauptträger verhindern.

2. Kraftfahrzeug-Leuchtvorrichtung (10) nach Anspruch 1, wobei der Hauptträger ein Gehäuse, ein optisches Element oder eine Blende ist.

3. Kraftfahrzeug-Leuchtvorrichtung (10) nach Anspruch 1, wobei der Hauptträger ein in einem Gehäuse, einem optischen Element oder einer Blende installiertes Hilfsteil ist.

4. Kraftfahrzeug-Leuchtvorrichtung (10) nach einem der Ansprüche 2 oder 3, wobei das optische Element ein Reflektor, eine Linse oder ein Lichtleiter ist.

5. Kraftfahrzeug-Leuchtvorrichtung (10) nach einem der vorstehenden Ansprüche, wobei die Befestigungsmittel eine Schraube (13) umfassen.

6. Kraftfahrzeug-Leuchtvorrichtung (10) nach einem der vorstehenden Ansprüche, wobei die Befestigungsvorrichtung einen Vorsprung umfasst und der Hauptträger einen Hohlraum aufweist, der zur Aufnahme des Vorsprungs ausgebildet ist.

7. Kraftfahrzeug-Leuchtvorrichtung (10) nach Anspruch 6, wobei der Vorsprung ein Stift oder ein Längsvorsprung ist.

8. Kraftfahrzeug-Leuchtvorrichtung (10) nach einem der vorstehenden Ansprüche, wobei die Befestigungsvorrichtung eine Clipverbindung umfasst.

9. Kraftfahrzeug-Leuchtvorrichtung (10) nach einem der vorstehenden Ansprüche, wobei das erste starre ebene Substrat (1) und das zweite starre ebene Substrat (2) parallel oder in derselben Ebene liegen.

10. Kraftfahrzeug-Leuchtvorrichtung (10) nach einem der Ansprüche 1 bis 8, wobei das erste starre ebene Substrat (1) und das zweite starre ebene Substrat (2) einen Winkel zwischen 60° und 300° bilden.

11. Kraftfahrzeug-Leuchtvorrichtung (10) nach einem der vorstehenden Ansprüche, wobei der Verbinder an einem angehobenen Element (14) angebracht ist, so dass der Abstand zwischen dem Verbinder und dem Hauptträger größer ist als der Abstand zwischen den starren ebenen Substraten und dem Hauptträger.

12. Kraftfahrzeug-Leuchtvorrichtung nach einem der vorstehenden Ansprüche, wobei jedes starre ebene Substrat (1, 2) ein optisches Element (15) umfasst, das so angeordnet ist, dass es das von der entsprechenden Lichtquelle (6) emittierte Licht empfängt und in einer Projektionsrichtung projiziert.

13. Kraftfahrzeug-Leuchtvorrichtung nach einem der vorstehenden Ansprüche, die ferner eine Außenlinse (16) umfasst, die so konfiguriert ist, dass sie das von den Lichtquellen emittierte Licht empfängt und außerhalb der Leuchtvorrichtung projiziert.

14. Kraftfahrzeug-Leuchtvorrichtung (10) nach einem der vorstehenden Ansprüche, wobei die Lichtquellen (6) Festkörperlichtquellen sind.

## Revendications

1. Dispositif lumineux pour véhicule automobile (10) comprenant
un support principal (3) ;
un premier substrat plan rigide (1) disposé sur le support principal (3) et comprenant une première borne (4) ;
un deuxième substrat plan rigide (2) disposé sur le support principal et comprenant des deuxièmes bornes (5), dans lequel au moins l'un des substrats plans rigides (1, 2) comprend au moins une source lumineuse (6) ; et
un connecteur (7) comprenant un corps de connecteur (8) et une pluralité de fils conducteurs (9), chaque fil conducteur (9) comprenant une première extrémité (11) déformée élastiquement contre l'une des premières bornes (4) et une deuxième extrémité (12) déformée élastiquement contre l'une des deuxièmes bornes (5),
**caractérisé en ce que** chaque extrémité de chaque fil conducteur (9) exerce une force de rappel contre la borne correspondante (4, 5) et de telle manière que chaque fil conducteur (9) assure une connexion électrique entre une première borne (4) et une deuxième borne (5) ;
dans lequel le connecteur (7) comprend des moyens de fixation (13) pour créer un joint entre le connecteur et le support principal, les moyens de fixation étant configurés pour empêcher la rotation et la translation entre le connecteur et le support principal.

2. Dispositif lumineux pour véhicule automobile (10) selon la revendication 1, dans lequel le support principal est un boîtier, un élément optique ou un enjoliveur.

3. Dispositif lumineux pour véhicule automobile (10) selon la revendication 1, dans lequel le support principal est une pièce auxiliaire installée dans un boîtier, un élément optique ou un enjoliveur.

4. Dispositif lumineux pour véhicule automobile (10) selon l'une quelconque des revendications 2 ou 3, dans lequel l'élément optique est un réflecteur, une lentille ou un guide de lumière.

5. Dispositif lumineux pour véhicule automobile (10) selon l'une quelconque des revendications précédentes, dans lequel le moyen de fixation comprend une vis (13).

6. Dispositif lumineux pour véhicule automobile (10) selon l'une quelconque des revendications précédentes, dans lequel le moyen de fixation comprend une saillie et le support principal comprend une partie creuse configurée pour recevoir la saillie.

7. Dispositif lumineux pour véhicule automobile (10) selon la revendication 6, dans lequel la saillie est un pion ou une saillie longitudinale.

8. Dispositif lumineux pour véhicule automobile (10) selon l'une quelconque des revendications précédentes, dans lequel le moyen de fixation comprend un joint à clip.

9. Dispositif lumineux pour véhicule automobile (10) selon l'une quelconque des revendications précédentes, dans lequel le premier substrat plan rigide (1) et le second substrat plan rigide (2) sont parallèles ou contenus dans le même plan.

10. Dispositif lumineux pour véhicule automobile (10) selon l'une quelconque des revendications 1 à 8, dans lequel le premier substrat plan rigide (1) et le second substrat plan rigide (2) forment un angle compris entre 60° et 300°.

11. Dispositif lumineux pour véhicule automobile (10) selon l'une quelconque des revendications précédentes, dans lequel le connecteur est installé sur un élément de surélévation (14), de sorte que la distance entre le connecteur et le support principal est supérieure à la distance entre les substrats plans rigides et le support principal.

12. Dispositif lumineux pour véhicule automobile selon l'une quelconque des revendications précédentes, dans lequel chaque substrat plan rigide (1, 2) comprend un élément optique (15) agencé pour recevoir la lumière émise par la source lumineuse correspondante (6) et projeter la lumière dans une direction de projection.

13. Dispositif lumineux pour véhicule automobile selon l'une quelconque des revendications précédentes, comprenant en outre une lentille externe (16) configurée pour recevoir la lumière émise par les sources lumineuses et la projeter à l'extérieur du dispositif lumineux.

14. Dispositif lumineux pour véhicule automobile (10) selon l'une quelconque des revendications précédentes, dans lequel les sources lumineuses (6) sont des sources lumineuses à semiconducteurs.
